# EUROPEAN PATENT APPLICATION

(11) **EP 0 867 293 A2**
(43) Date of publication of application: **30.09.1998**
(21) Application number: 98302341.7
(22) Date of filing: 27.03.1998
(51) Int. Cl.: B41J 2/16, B41J 2/175

(54) **Process for joining a flexible circuit to a polymeric container and for forming a barrier layer over sections of the flexible circuit and other elements using an encapsulant material**

(30) Priority: 27.03.1997 US 827140
(71) Applicant: Lexmark International, Inc., Lexington, Kentucky 40551 (US)
(72) Inventor: Singh, Jeanne Marie Saldanha, Lexington, Kentucky 40514 (US); Williams, Gary Raymond, Lexington, Kentucky 40517 (US); Surgener, Phyllis Curry, Lexington, Kentucky 40504 (US); Lowry, Edwina Floyd, Lexington, Kentucky 40513 (US); Jackson, Tonya Harris, Lexington, Kentucky 40514 (US); Haarz, Leea Danielle, Lexington, Kentucky 40503 (US); Derossett, William May, Jr., Lexington, Kentucky 40505 (US)
(74) Representative: Tomlinson, Kerry John

(57) **Abstract**

A method is provided for sealing at least one outer portion of an ink jet print cartridge (10). The method comprises the steps of providing a dispensing element (70) having an oval discharge orifice, and dispensing an encapsulant material onto the at least one outer portion via the dispensing element so as to provide a barrier layer over the at least one outer portion. Further provided is a process for joining a flexible circuit (30) to an ink jet print cartridge container (12). The method comprises the steps of applying a silane adhesion promoter to a portion of the container, applying an adhesive to at least a part of the silane-coated portion, and adhering the flexible circuit to the container via the adhesive.

## Description

This invention relates to a process for joining a flexible circuit to an ink jet print cartridge container and to a process for forming a barrier layer over one or more extending sections of a flexible circuit and one or more bond pads of a printhead using an encapsulant material.

Drop-on-demand ink jet printers use thermal energy to produce a vapor bubble in an ink-filled chamber to expel a droplet. A thermal energy generator or heating element, usually a resistor, is located in the chamber on a heater chip near a discharge orifice. A plurality of chambers, each provided with a single heating element, are provided in the printer's printhead. The printhead typically comprises the heater chip and a plate having a plurality of the discharge orifices formed therein. The printhead forms part of an ink jet print cartridge which also comprises an ink-filled container.

The resistors are individually addressed with an energy pulse to momentarily vaporize the ink and form a bubble which expels an ink droplet. A flexible circuit is used to provide a path for energy pulses to travel from a printer energy supply circuit to the printhead. The flexible circuit includes a substrate portion and a plurality of traces located on the substrate portion. The traces have end sections which extend out from the substrate portion. The extending sections are coupled to bond pads on the printhead. Typically, there is a first row of coupled bond pads and trace sections and an opposing, second row of coupled bond pads and trace sections.

It is known in the art to form a barrier layer over each row of coupled bond pads and extending trace sections. One known process for forming such a barrier layer involves dispensing an encapsulant material onto the coupled bond pads and trace sections using a discharge needle having a circular cross section. In order to form each barrier layer to the required width and to protect printhead circuitry, two complete passes of the needle are made over each row of coupled bond pads and trace sections.

As two passes of the needle are required to form an acceptable barrier layer, this process is time consuming. Further, because of the circular cross section of the needle, the final height of the barrier layer relative to the flexible circuit is undesirably high, e.g., normally greater than .007 inch (0.18mm). As a result, a paper substrate, which receives the ejected ink droplets, is spaced an increased distance from the printhead orifice plate. Consequently, misdirected ink droplets reach the paper substrate at locations which are spaced a greater distance from their intended contact points than if the paper substrate were located closer to the printhead orifice plate. The excessive height of the two barrier layers is further problematic as it makes it more difficult to apply a length of sealing tape to the printhead so as to seal the printhead orifices from ink leakage until the print cartridge is installed for use in a printer.

Accordingly, there is a need for an improved process for forming barrier layers over printhead bond pads and extending trace sections.

In addition to the above, there is a need for an improved process for adhesively joining a flexible circuit to an ink jet print cartridge container so as to provide improved adhesion at the adhesive-container interface.

These needs are met by the improved processes, print cartridges and apparatus of the present invention. In accordance with one aspect of the present invention, a dispensing needle having an oval discharge orifice is used to dispense a single bead of encapsulant material, e.g., a polymeric adhesive material, over a row of coupled bond pads and extending trace sections. The bead height is reduced due to the oval cross section of the dispensing needle. Hence, the paper substrate, which receives the ejected ink droplets, may be moved closer to the printhead, so as to improve print quality. Further, sealing tape may be applied more easily and effectively to the printhead. As only a single pass is required to form a barrier layer having an acceptable width, this process is more efficient than the prior art process noted above. Additionally, when the encapsulant material comprises an ultraviolet curable thermoset, improved curing depth is achieved with the lower bead height. Such lower bead heights ensure proper capping at the maintenance station to prevent ink leakage.

In accordance with a second aspect of the present invention, an adhesion promoter, such as a silane solution, is applied to a portion of a print cartridge container before a flexible circuit is adhesively coupled to the container. The adhesion promoter improves adhesion at the adhesive-container interface.

Certain embodiments of the invention will now be described by way of example only and with reference to the accompanying drawings, in which:
Fig. 1 is a perspective view of a portion of an ink jet print cartridge formed in accordance with the present invention;
Fig. 1A is a plan view of a portion of a printhead showing an outer surface of a section of the orifice plate, another section of the orifice plate having a portion partially removed, and the surface of a portion of the heater chip with the section of the orifice plate above that chip portion completely removed;
Fig. 2 is an enlarged view of the printhead, a portion of the flexible circuit, and a portion of the ink-filled container shown in Fig. 1;
Fig. 3 is a side view of an encapsulant material dispensing apparatus and an ink jet print cartridge where the cartridge is positioned to receive encapsulant material from the dispensing apparatus;
Fig. 4 is a view taken along view line 4-4 in Fig. 3;
Fig. 5 is a perspective view of a portion of an ink jet print cartridge formed in accordance with the present invention and shown having a length of sealing tape provided thereon;
Fig. 6 is a view taken along view line 6-6 in Fig. 5; and
Fig. 7 is an exploded view of the ink jet print cartridge shown in Fig. 1 without the printhead.

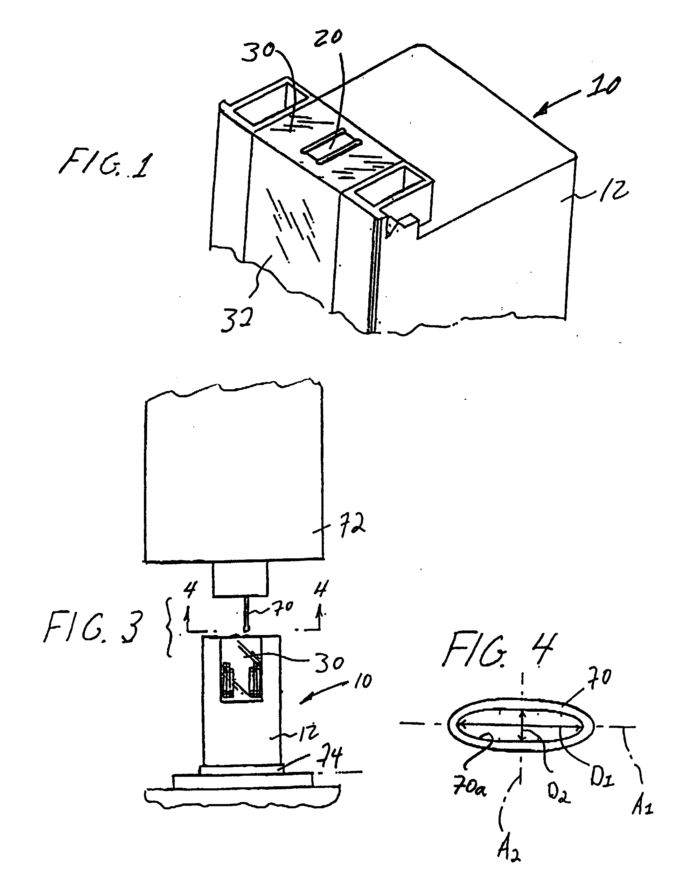

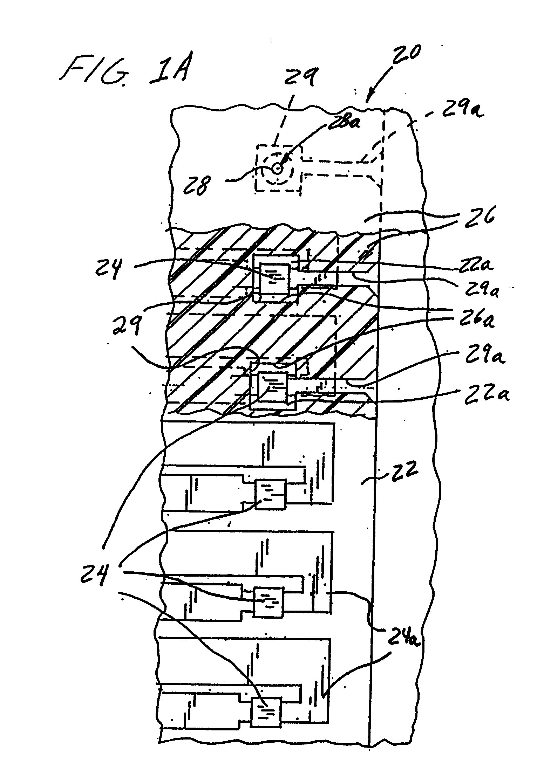

Referring now to Fig. 1, there is shown an ink jet print cartridge 10 constructed in accordance with the present invention. It is adapted to be used in an ink jet printer (not shown). The print cartridge 10 comprises an ink-filled polymeric container 12, a printhead 20 which is adhesively secured to the container 12, and a flexible circuit 30 (also referred to as a TAB circuit).

The printhead 20 comprises a heater chip 22 provided with a plurality of resistive heating elements 24, see Fig. lA. The printhead 20 further includes an orifice plate 26 having a plurality of openings 28 extending through it which define a plurality of orifices 28a through which ink droplets are ejected. Sections 26a of the plate 26 and portions 22a of the heater chip 22 define a plurality of bubble chambers 29. Ink supplied by the container 12 flows into the bubble chambers 29 through ink supply channels 29a.

The resistive heating elements 24 are individually addressed by voltage pulses. Each voltage pulse is applied to a heating element 24 to momentarily vaporize the ink in contact with the heating element 24 to form a bubble within the chamber 29 in which the heating element 24 is located. The function of the bubble is to displace ink within the chamber 29 such that a droplet of ink is expelled through the bubble chamber orifice 28a.

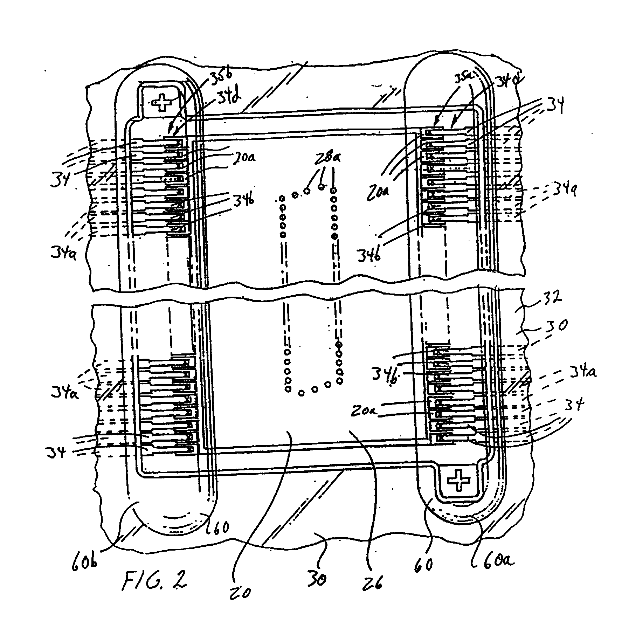

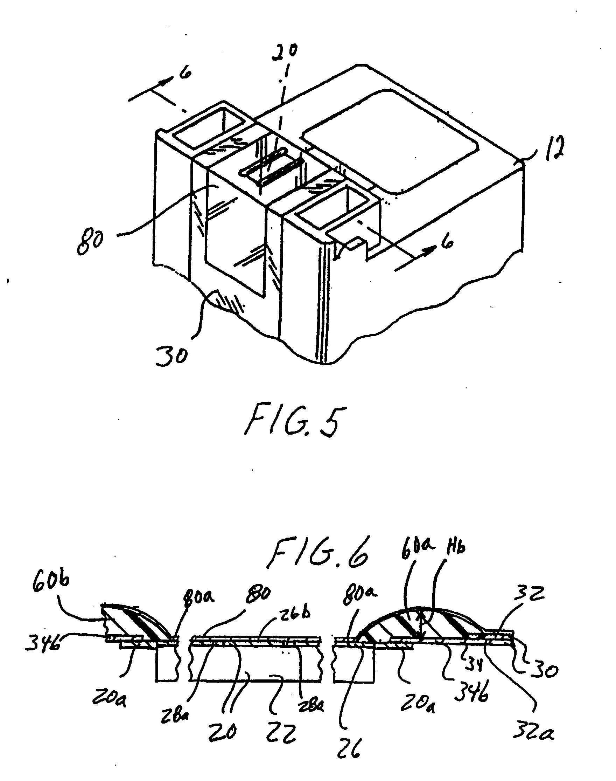

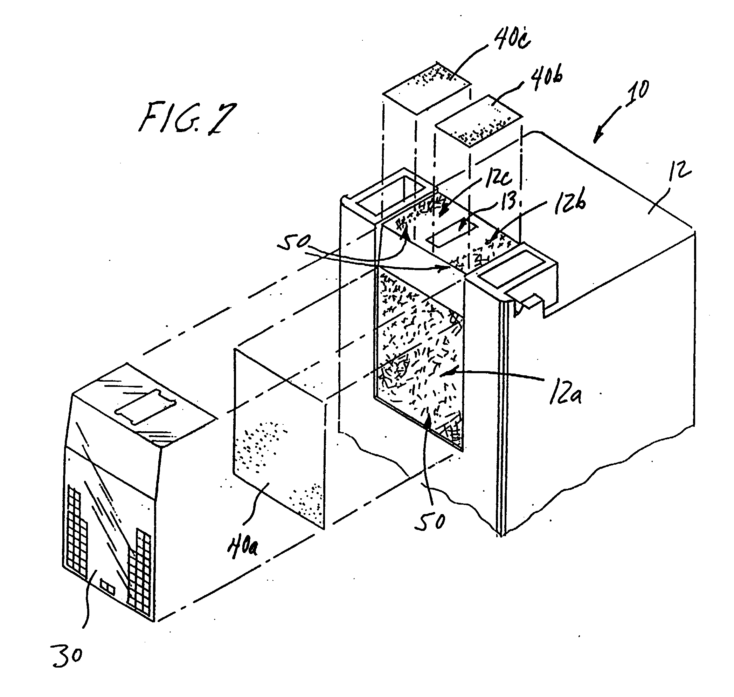

The flexible circuit 30 provides a path for voltage pulses to travel from a printer energy supply circuit (not shown) to bond pads 20a, see Fig. 2, provided on the printhead 20. Conductors 24a extend from the bond pads 20a to the heating elements 24, see Fig. lA.

The flexible circuit 30 comprises a substrate portion 32 and a plurality of metallic traces 34 formed on a first side 32a of the substrate portion 32, see Figs. 2 and 6. The traces 34 have main body sections 34a and end sections 34b. The main body sections 34a are formed on the substrate portion 32 and the end sections 34b extend out from the substrate portion 32. The end sections 34b define first and second rows of beam leads 34c and 34d. The first side 32a of the substrate portion 32 faces the container 12 such that the main body sections 34a are positioned between the substrate portion 32 and the container 12. An epoxy coating (not shown) may be applied over the main body sections 34a so as to prevent ink from contacting those sections 34a.

The extending end sections 34b are coupled to the bond pads 20a via a conventional Tape Automated Bonding (TAB) bonding process. Preferably, the TAB bonding process is performed before either the printhead 20 or the flexible circuit 30 is secured to the container 12. Typically, there is a first row 35a of coupled bond pads 20a and trace sections 34b and an opposing, second row 35b of coupled bond pads 20a and trace sections 34b, see Fig. 2. The first and second rows 35a and 35b of coupled bond pads 20a and trace sections 34b are also referred to herein as first and second outer portions of the print cartridge 10.

The polymeric container 12 may be formed from polyphenylene oxide, which is commercially available from the General Electric Company under the trademark "NORYL SE-1". The substrate portion 32 is preferably formed from a polymeric material, such as a polyimide material commercially available from E.I. DuPont de Nemours & Co. under the trademark "KAPTON." In the illustrated embodiment, the metallic traces 34 are gold-coated copper traces. The specific materials from which the container 12, the substrate portion 32 and metallic traces 34 are formed are mentioned herein for illustrative purposes only. Hence, in this invention, the materials from which these elements are formed are not intended to be limited to the specific ones disclosed herein.

A die-attach adhesive (not shown), a heat curable epoxy-based polymer in the illustrated embodiment, is applied to a printhead receiving portion 13 of the container 12, see Fig. 7. An example of such an adhesive is one which is a commercially available polymeric material such as epoxy-type or silicone based adhesive. Typically, the adhesive is placed on the container and cured via conventional methods.

In the illustrated embodiment, a free-standing pressure sensitive adhesive film is used to secure the flexible circuit 30 to the container 12. Three separate sections 40a-40c of the pressure sensitive adhesive film are applied to three portions 12a-12c of the container 12 which receive the circuit 30, see Fig. 7. The film sections 40a-40c are preferably applied to the container portions 1 2a-1 2c before the die-attach adhesive is applied to the printhead receiving portion 13. Example pressure sensitive adhesive films include: 1) a .002 inch (0.05mm) thick acrylic adhesive film commercially available from 3M Corporation under the product designation "9460"; 2) a .005 inch (0.13mm) thick acrylic adhesive film commercially available from 3M Corporation under the product designation "9885"; 3) a .002 inch (0.05mm) thick acrylic adhesive film commercially available from Ashland Chemical Company, Specialty Polymers and Adhesives Division under the trademark "AEROSET 1 860Z-45"; and 4) a .002 inch (0.05mm) thick acrylic adhesive film commercially available from Ashland Chemical Company, Specialty Polymers and Adhesives Division under the trademark "AEROSET 1930-Z47".

In accordance with the present invention, an adhesion promoter 50 may be applied directly to the first, second and third container portions 12a-12c before they receive the adhesive film sections 40a-40c. After the film sections 40a-40c are applied to the container 12, the flexible circuit 30 with the printhead 20 bonded to it is attached to the container 12 with pressure being applied. As will be discussed further below, the container 12, after receiving the film sections 40a-40c, the flexible circuit 30 and the printhead 20, is heated to a temperature of about greater than ambient to about less than the glass transition temperature of the container 12, and preferably, from about 100°C to about 120°C for at least about 30 minutes and preferably for about 45 minutes to effect the curing of the die-attach adhesive. When an adhesion promoter 50 is not used, premature adhesion failure may occur at the container-adhesive interface as a result of this heating step. Use of the adhesion promoter 50 improves adhesion at the adhesive-container interface after the container 12, with the adhesive film sections 40a-40c secured thereto, has been heated to effect the curing of the die-attach adhesive.

While it is within the scope of this invention to vary the components of the adhesion promoter 50, the adhesion promoter 50 is preferably prepared as a solution comprising about 0.1 to about 1.0% by volume of silane; greater than about 98% by volume of denatured ethanol; and 0.2 to about 0.4% by volume of deionized water. The silane may comprise either of two silanes which are commercially available from Dow Corning Corporation under the product designations "Z6030" and "Z6032". The three components are mixed at ambient temperature and allowed to stabilize. The solution may be applied to the container portions 12a-12c about one hour after mixing. The solution is stable for about one week if kept at ambient conditions.

The adhesion promoter solution is preferably applied manually using a commercially available grout sealer pen (not shown) from Color Tile under Stock No. 7893217. Alternatively, other applicators such as brushes and the like may be used.

Approximately about two minutes to about four hours after the adhesion promoter solution has been applied to the container 12, the three pressure sensitive adhesive sections 40a-40c are secured under pressure to the container portions 12a-12c. The adhesive sections 40a-40c preferably have release liners (not shown) covering their outer surfaces, which surfaces will engage the flexible circuit 30. The release liners are removed just before the flexible circuit 30 is secured to the container 12.

After the die-attach adhesive has been applied to the printhead receiving portion 13 and the release liners have been removed from the adhesive sections 40a-40c, the coupled printhead 20 and flexible circuit 30 is secured to the container 12. The flexible circuit 30 is pressed against the sections 40a-40c under sufficient pressure to effect bonding between the sections 40a-40c and the circuit 30. As will be discussed further below, the cartridge 10 is heated in an oven maintained at a temperature of about 110°C for approximately 45 minutes so as to effect the curing of the die-attach adhesive.

Before the die-attach adhesive is cured, a single bead of liquid encapsulant material 60 is applied over each of the two rows 35a and 35b of coupled bond pads 20a and extending trace sections 34b. The liquid encapsulant material is preferably dispensed through a dispensing needle 70 having an oval cross section, see Figs. 3 and 4. In the illustrated embodiment, the dispensing needle 70 is attached to a conventional dispensing apparatus 72 having a dispense pump (not shown) which forces encapsulant material 60 from a tube of encapsulant material (not shown) into and through the dispensing needle 70. The apparatus 72 also has a traversing mechanism (not shown) which moves the needle 70 along dispensing paths so as to allow the needle 70 to deposit the material 60 along the two rows 35a and 35b. A workpiece holder 74 is provided to fixedly hold the container 12 beneath the dispensing needle 70. It is also contemplated that the material 60 may be manually dispensed through the needle 70 using a conventional syringe.

The encapsulant material 60 forms a first barrier layer 60a over row 35a and a second barrier layer 60b over row 35b, see Fig. 2. The encapsulant material 60 may comprise any polymeric material which, after it has substantially solidified or cured, is capable of forming an effective mechanical and chemical protective barrier layer over each of the two rows 35a and 35b of coupled bond pads 20a and extending trace sections 34b. The bond pads 20a are made from aluminum in the illustrated embodiment. The barrier layers 60a and 60b protect the bond pads 20a from corrosion due to exposure to ink. The barrier layers 60a and 60a further protect the bond pads 20a and extending sections 34a from damage caused by a conventional polymeric wiper (not shown) which forms part of the printer and moves across the plate 26 so as to remove ink therefrom. The encapsulant material 60 may comprise a urethane acrylate material which is commercially available from Grace Specialty Polymers Division of W.R. Grace and Company under the trademark "UNISET UV-9000." This material is an ultraviolet light (UV) cured material and has a viscosity of about 11,000 centipoise (11Pa.s) at about 25°C when measured with a Brookfield viscometer, Model HATB. Other thermoset or thermoplastic encapsulant materials not specifically set out herein may also be used.

Preferably, the needle 70 has an oval discharge orifice 70a, see Fig. 4, having a first dimension D₁ along a first axis A₁ and second dimension D₂ along a second axis A₂. The second dimension D₂ is less than the first dimension D1. The second axis A₂ is substantially orthogonal to the first axis A₁. A ratio of the first dimension D₁ to the second dimension D₂ is greater than or equal to about 1.1:1.0 and less than or equal to about 7.0:1.0, and most preferably is about 4.0:1.0. For example, D₁ may be equal to about 2 mm and D₂ may be equal to about .5 mm. The only limitation with respect to the distance and orientation of the oval discharge orifice with respect to the beam leads is that when the encapsulant material is applied, the printhead 20 is attached to the flexible circuit 30. Preferably, however, the long or first axis A₁ of the oval discharge orifice 70a is orthogonal to the long axis of the encapsulant bead and the row 35a or 35b to which the encapsulant material 60 is applied.

Due to the oval shape of the discharge orifice 70a, the height of the bead of encapsulant material dispensed onto each of the two rows 35a and 35b of coupled bond pads 20a and extending trace sections 34b is reduced over bead height achieved using a needle having a substantially circular cross section. If the encapsulant material is a UV curable thermoset, improved curing depth is achieved as a result of reduced bead height.

Preferably, the maximum height H_{b} of the encapsulant material after it has solidified or cured, as measured from the upper portion 26b of plate 26 to the highest portion or point of the solidified or cured encapsulant bead is less than about .02 inch (0.5mm), see Fig. 6. More preferably, the maximum height H_{b} is less than about .007 inch (0.18mm), and most preferably, is from about .004 inch (0.lmm) to about .006 inch (0.15mm). Because of reduced barrier layer height, a paper substrate, which receives the ejected ink droplets, may be moved closer to the printhead 20 so as to improve print quality. Further, sealing tape 80, see Fig. 6, which seals the orifices 28a from ink leakage until removed just prior to installation of the cartridge 12 in an ink jet printer (not shown), may be applied more easily and effectively to the printhead 20. If barrier layer height is too great, portions 80a of the tape 80 adjacent to the barrier layers 60a and 60b tend not to adhere to the printhead 20 and, hence, ink leakage occurs around the unsealed regions of the printhead 20.

In order to keep orifices 28a from drying out when the installed printhead 20 is not in use, a polymeric cap (not shown) forming part of the printer is sealed over the printhead. If the height of the barrier layers 60a and 60b is too excessive and the polymeric cap is out of tolerances such that it engages one or both of the barrier layers 60a and 60b, adequate sealing may not be achieved. With lower barrier layer height, the likelihood of proper capping is increased.

A further advantage resulting from the oval shape of the discharge orifice 70a is that only a single pass of the needle 70 is required over each of the two rows 35a and 35b of coupled bond pads 20a and extending trace sections 34b to form a barrier layer having an acceptable width. Accordingly, this process is more efficient than prior art processes which require two or more passes to form an acceptable barrier layer.

The encapsulant material 60 may have a viscosity of between about 7,000 centipoise (7Pa.s) and about 60,000 centipoise (60Pa.s) at 25°C, as measured by a Brookfield viscometer, model HATB with appropriate spindle at 0.5 RPM. Another advantage resulting from the oval shape of the discharge orifice 70a is that a higher viscosity encapsulant material 60 may be used. Generally, a higher viscosity material results in a higher bead height. However, with a higher viscosity material, less sag or drop of the encapsulant material between the extending trace sections 34b occurs. Hence, a more uniform barrier layer outer surface is formed. Accordingly, because bead height is reduced in the present invention, a higher viscosity encapsulant material may be used. Examples of high viscosity materials that may be employed include: 1) a thermoset adhesive which is commercially available from W.R. Grace and Company under the trademark "Uniset 3032-78," having a viscosity of approximately 50,000 centipoise (50Pa.s) at 25°C, when measured using a Brookfield viscometer, Model HATB with spindle 52; and a thermoset adhesive which is commercially available from Ablestik Company under the trademark "Ablebond 84-3," having a viscosity of approximately 50,000 centipoise (50Pa.s) at 25°C when measured using a Brookfield viscometer, Model HBT-DCP with spindle CP-51.

After the beads of encapsulant material 60 have been applied to the two rows 35a and 35b of coupled bond pads 20a and extending trace sections 34b, the encapsulant material 60 is cured via exposure to ultraviolet radiation. Thereafter, the die-attach adhesive is cured by placing the cartridge 10 in a heated oven maintained at a temperature of about 110°C for approximately 45 minutes.

The following example is being provided for illustrative purposes only and is not intended to be limiting.

### EXAMPLE 1

An adhesion promoter solution was prepared by combining approximately 85 ml of ethanol; approximately .5 ml of silane (Z6032); and approximately 50 drops of deionized water. After the mixture was gently mixed and allowed to stabilize for one hour, the solution was applied to second and third portions 12b and 12c of a first ink jet print cartridge container formed from polyphenylene oxide. Two separate sections of adhesive film (commercially available from 3M Corporation under the product designation "9460") were applied to the second and third container portions. A first flexible circuit was then applied to the pressure sensitive adhesive sections. As a third section of adhesive film was not applied to the first container portion 12a, the flexible circuit was not folded down and secured to container portion 12a. A second container, which was not coated with the adhesion promoter solution, received two separate sections of the same adhesive film. A flexible circuit was then secured to the container via the two sections of pressure sensitive adhesive film.

A die-attach adhesive was not applied to the first and second containers. The first and second containers, having flexible circuits joined thereto, were heated in an oven maintained at at about 110°C for about 45 minutes.

Adhesion of each flexible circuit to its respective container was measured after heating using an Instron testing machine. Each container was placed in the testing machine. Movable grips, forming part of the machine, were secured to each container's unsecured section of the flexible circuit so as to apply a pulling force to the flexible circuit. The containers were held fixed in the testing machine. Approximately 300 grams of force were required to peel the flexible circuit from the first container while approximately 230 grams of force were required to peel the flexible circuit from the second container. Hence, peel strength improved by at least 30% when an adhesion promoter 50 was applied.

The mode of failure for the first container was within the adhesive layer, not at the adhesive-container interface. The mode of failure for the second container was at the adhesive-container interface.

## Claims

1. A method for sealing at least one outer portion of an ink jet print cartridge comprising the steps of:
providing a dispensing element having an oval discharge orifice; and
dispensing an encapsulant material onto said at least one outer portion via said dispensing element so as to provide a barrier layer over said at least one outer portion.

2. A method as set forth in claim 1, wherein said ink jet print cartridge comprises:
a polymeric container adapted to receive ink;
a printhead coupled to said container and having at least one bond pad;
a flexible circuit including a substrate portion and at least one conductor trace on said substrate portion and having an end section which extends out from said substrate portion to define at least one beam lead, said at least one beam lead being coupled to said at least one bond pad; and
said outer portion of said ink jet print cartridge comprising said at least one bond pad and said at least one beam lead.

3. A method as set forth in claim 1 or 2, wherein said dispensing step comprises the step of moving one of said dispensing element and said outer portion relative to the other such that only a single bead of encapsulant material is applied to said outer portion, said single bead of encapsulant material being sufficient to substantially completely cover said outer portion.

4. A method as set forth in claim 1, 2 or 3, wherein said dispensing step comprises the step of dispensing a polymeric encapsulant material onto said outer portion such that after said polymeric material has substantially cured or solidified it has a height which is less than about .02 inch (0.5mm).

5. A method as set forth in claim 4, wherein said dispensing step comprises the step of dispensing a polymeric encapsulant material onto said outer portion such that after said polymeric material has cured or solidified it has a height which is between about .004 inch (0.1mm) and about .006 inch (0.15mm).

6. A method as set forth in any preceding claim, wherein said dispensing step comprises the step of dispensing a polymeric material onto said outer portion.

7. A method as set forth in claim 6, wherein said polymeric material comprises a urethane acrylate material.

8. A method as set forth in any preceding claim, wherein said dispensing step comprises the step of dispensing a polymeric material onto said outer portion having a viscosity between about 7,000 centipoise (7Pa.s) and about 60,000 centipoise (60Pa.s).

9. A method as set forth in any preceding claim, wherein said ink jet print cartridge comprises:
a polymeric container adapted to receive ink;
a printhead coupled to said container and having a first row of bond pads located on a first side of said printhead and a second row of bond pads which are located on a second side of said printhead which is opposite to said first side;
a flexible circuit including a substrate portion and a plurality of conductor traces provided on said substrate portion and having end sections which extend out from said substrate portion to define first and second rows of beam leads, said first row of beam leads being coupled to said first row of bond pads and said second row of beam leads being coupled to said second row of bond pads, said coupled first bond pads and beam leads defining a first print cartridge outer portion and said coupled second bond pads and beam leads defining a second print cartridge outer portion.

10. A method as set forth in claim 9, wherein said dispensing step comprises the steps of:
moving one of said dispensing element and said first outer portion relative to the other such that only a single bead of encapsulant material is applied over said first outer portion, said single bead of encapsulant material being sufficient to substantially completely cover said first outer portion; and
moving one of said dispensing element and said second outer portion relative to the other such that only a single bead of encapsulant material is applied onto said second outer portion, said single bead of encapsulant material being sufficient to substantially completely cover said second outer portion.

11. A method as set forth in any preceding claim, wherein said oval discharge orifice has a first dimension along a first axis and second dimension along a second axis which is less than said first dimension, said second axis being substantially orthogonal to said first axis, and a ratio of said of first dimension to said second dimension is greater than or equal to about 1.1:1 and less than or equal to about 7:1.

12. An ink jet print cartridge comprising:
at least one outer portion; and
a bead of encapsulant material provided over said at least one outer portion so as to provide a barrier layer over said outer portion, said barrier layer having a height which is less than about .007 inch (0.18mm).

13. An ink jet print cartridge as set forth in claim 12, further comprising:
a polymeric container adapted to receive ink;
a printhead coupled to said container and having at least one bond pad; and
a flexible circuit including a substrate portion and at least one conductor trace provided on said substrate portion and having an end section which extends out from said substrate portion to define at least one beam lead, said at least one beam lead being coupled to said at least one bond pad, and said coupled beam lead and bond pad defining said outer portion.

14. An ink jet print cartridge as set forth in claim 12 or 13, wherein said barrier layer has a height which is between about .004 inch (0.lmm) and about .006 inch (0.15mm).

15. An ink jet print cartridge as set forth in claim 12, 13 or 14, wherein said encapsulant material comprises a polymeric material.

16. An ink jet print cartridge as set forth in claim 15, wherein said polymeric material comprises a urethane acrylate material.

17. An ink jet print cartridge as set forth in any of claims 12 to 16, further comprising:
a polymeric container adapted to receive ink;
a printhead coupled to said container and having a first row of bond pads located on a first side of said printhead and a second row of bond pads which are located on a second side of said printhead which is opposite to said first side;
a flexible circuit including a substrate portion and a plurality of conductor traces provided on said substrate portion and having end sections which extend out from said substrate portion to define first and second rows of beam leads, said first row of beam leads being coupled to said first row of bond pads and said second row of beam leads being coupled to said second row of bond pads, said coupled first beam leads and bond pads defining a first outer portion of said print cartridge and said coupled second beam leads and bond pads defining a second outer portion of said print cartridge; and
a first bead of encapsulant material provided over said first outer portion and forming a barrier layer over said first outer portion and a second bead of encapsulant material provided over said second outer portion and forming a barrier layer over said second outer portion, said first and second barrier layers having a height which is less than about .02 inch (0.5mm).

18. An ink jet print cartridge as set forth in claim 17, wherein said first and second barrier layers have a height which is between about .004 inch (0.lmm) and about .006 inch (0.15mm).

19. A process for joining a flexible circuit to an ink jet print cartridge container comprising the steps of:
coating a silane adhesion promoter to a portion of said container;
applying an adhesive to at least a part of said silane-coated portion; and
adhering said flexible circuit to said container via said adhesive.

20. A process as set forth in claim 19, wherein said step of applying an adhesive comprises the step of applying an acrylic pressure-sensitive adhesive to said at least a part of said silane-coated portion.

21. A process as set forth in claim 19 or 20, wherein said silane adhesion promoter is applied to said container with a grout sealer pen.

22. An ink jet print cartridge comprising:
a polymeric container adapted to receive ink;
a printhead coupled to said container;
a layer of silane coated on a portion of said container;
a layer of adhesive provided on at least a part of said silane-coated portion; and
a flexible circuit including a substrate portion adhered to said container via said adhesive layer.

23. An ink jet print cartridge as set forth in claim 22, wherein said printhead has at least one bond pad and said flexible circuit has at least one conductor trace provided on said substrate portion, said conductor trace having an end section which extends out from said substrate portion to define at least one beam lead, said at least one beam lead being coupled to said at least one bond pad, and said coupled beam lead and bond pad defining an outer portion of said ink jet print cartridge.

24. An ink jet print cartridge as set forth in claim 23, further including a bead of encapsulant material provided over said outer portion so as to form a barrier layer over said outer portion, said barrier layer having a height which is less than about .02 inch (0.5mm).

25. An ink jet print cartridge as set forth in claim 22, 23 or 24, wherein said encapsulant material comprises a polymeric material.

26. An ink jet print cartridge as set forth in claim 25, wherein said polymeric material comprises a urethane acrylate material.

27. An ink jet print cartridge as set forth in claim 24, said barrier layer having a height which is between about .004 inch (0.lmm) and about .006 inch (0.15mm).

28. An ink jet print cartridge comprising:
a polymeric container adapted to receive ink;
a printhead coupled to said container, said printhead having at least one bond pad;
a layer of an adhesion promoter provided on a portion of said container;
a layer of adhesive provided over at least a part of said adhesion promoter on said container portion;
a flexible circuit adhered to said container via said adhesive layer, said flexible circuit including a substrate portion and at least one conductor trace provided on said substrate portion and having an end section which extends out from said substrate portion to define at least one beam lead, said at least one beam lead being coupled to said at least one bond pad, and said coupled beam lead and bond pad defining an outer portion of said ink jet print cartridge; and
a bead of encapsulant material provided over said outer portion so as to form a barrier layer over said outer portion, said barrier layer having a height which is less than about .01 inch (0.25mm).

29. An ink jet print cartridge as set forth in claim 28, wherein said barrier layer has a height which is between about .004 inch (0.lmm) and about .006 inch (0.15mm).

30. An ink jet print cartridge as set forth in claim 28 or 29, wherein said encapsulant material comprises a polymeric material.

31. An ink jet print cartridge as set forth in claim 30, wherein said polymeric material comprises a urethane acrylate material.

32. A process for joining a flexible circuit and a printhead to an ink jet print cartridge container comprising the steps of:
applying a die-attach adhesive to a first portion of said container;
coating an adhesive promoter to at least one second portion of said container;
securing a second adhesive to said at least one second portion;
bonding a flexible circuit to a printhead;
securing said flexible circuit to said second container portion such that said printhead contacts said die-attach adhesive; and
curing said die-attach adhesive.

33. A process as set forth in claim 32, wherein said curing step comprises placing said container with said flexible circuit and said printhead in a heated oven maintained at a temperature of from about 100°C to about 120°C for a sufficient amount of time to effect curing of said die-attach adhesive.

34. A process as set forth in claim 32 or 33, wherein said adhesion promoter comprises a silane adhesion promoter.

35. A process as set forth in claim 32, 33 or 34, wherein said applying step follows said coating step.

36. A process as set forth in any of claims 32 to 35, wherein said curing step comprises placing said container with said flexible circuit and said printhead in a heated oven for a sufficient amount of time to effect the curing of said die-attach adhesive.
